# EUROPÄISCHE PATENTSCHRIFT

(11) **EP 1 860 565 B1**
(45) Veröffentlichungstag und Bekanntmachung des Hinweises auf die Patenterteilung: **17.08.2011**
(21) Anmeldenummer: 07009522.9
(22) Anmeldetag: 11.05.2007
(51) Int. Cl.: G06F 11/20, G01R 31/317, G07C 5/08, B60R 21/017, B60T 8/88, B60W 50/04, G05B 17/02, G05B 23/02

(54) **Verfahren zur Funktionsprüfung eines Steuergeräts für ein Kraftfahrzeug**
Method for performing a functional check of the control unit for a motor vehicle
Procédé destiné à la vérification du fonctionnement d'un appareil de commande pour un véhicule automobile

(30) Priorität: 26.05.2006 DE 102006024606
(43) Veröffentlichungstag der Anmeldung: 28.11.2007
(73) Patentinhaber: Bayerische Motoren Werke Aktiengesellschaft, 80809 München (DE)
(72) Erfinder: Weidner, Marcus, 82362 Weilheim (DE); Baur, Richard, 85276 Pfaffenhofen (DE); Schuster, Erik Marc, 85716 Unterschleissheim (DE)

(56) Entgegenhaltungen:
- EP-A2- 0 283 015
- DE-A1- 4 005 299
- DE-A1- 4 333 009
- DE-A1- 10 220 812
- DE-A1- 19 833 815
- US-A- 5 550 762

## Beschreibung

Die Erfindung betrifft ein Verfahren zur Funktionsprüfung eines Steuergeräts für ein Kraftfahrzeug.

Aus dem Stand der Technik sind verschiedenste Verfahren zur Funktionsprüfung von Steuergeräten bekannt.

Beispielsweise ist aus der DE 10018206 A1 ein Verfahren zur Fehlersimulation in einer elektrischen Baugruppe bekannt, bei dem die elektrische Baugruppe aus elektrischen Komponenten besteht und durch die Baugruppe Betriebsabläufe durchgeführt werden, und zumindest einer elektrischen Komponente zumindest ein mögliches Fehlerereignis zugeordnet wird. Für die auftretenden Fehlerereignisse der jeweiligen Komponente wird ein das jeweilige Fehlerereignis simulierendes Ersatzelement vorgesehen und zur Simulation des jeweiligen Fehlerereignisses mittels elektrischer Kontaktpunkte in der Baugruppe und steuerbarer Schaltmittel wird anstelle der jeweiligen Komponente das jeweilige Ersatzelement zugeschaltet. Währenddessen wird an zumindest einer Messstelle in der Baugruppe die Auswirkung dieses Fehlerereignisses auf die Betriebsabläufe erfasst.

Das aus der DE 10018206 A1 bekannte Verfahren impliziert einen sehr hohen Hardware-Aufwand. Zudem sind nur solche Fehlerereignisse der Baugruppe beeinflussbar, welche durch ein ersatzweise zugeschaltetes Ersatzelement simulierbar sind.

Bekannt ist es außerdem, das Verhalten einer Vorrichtung, beispielsweise eines Sensors, welche über eine externe Kommunikationsschnittstelle mit einem Steuergerät verbindbar ist, zu simulieren und die Kommunikationsschnittstelle mit einem bei der Simulation gewonnenen Kommunikationssignal zu beaufschlagen. Statt einer Signalgewinnung durch Simulation können auch reale Kommunikationssignale aufgezeichnet werden. Das auf das Steuergerät bezogene Verhalten der verbindbaren Vorrichtung kann auf diese Weise emuliert werden. Durch eine solche Emulation lassen sich jedoch nur Betriebszustände vorgeben, die vorhersehbar von Eingangssignalen der Kommunikationsschnittstellen des Steuergeräts abhängen.

Aufgabe der Erfindung ist es, ein einfaches Verfahren zur Funktionsprüfung eines Steuergeräts für ein Kraftfahrzeug zu schaffen, welches eine unkomplizierte Überprüfung eines abzusichernden Betriebszustands des Steuergeräts ermöglicht.

Diese Aufgabe wird erfindungsgemäß gelöst durch ein Verfahren gemäß Patentanspruch 1.

Erfindungsgemäß wird ein Testsignal erzeugt, welches einen abzusichernden internen Fehlerzustand zumindest eines Teils des Steuergeräts beschreibt. Im einfachsten Fall wird durch das Testsignal ein Zustand einer einzigen Zustandsgröße des Steuergeräts beschrieben. Das Testsignal kann aber im umgekehrten Extremfall auch sämtliche Zustandsgrößen des gesamten Steuergeräts vollumfänglich und eindeutig beschreiben. Beispielsweise kann das Testsignal ein definiertes Gesamtverhalten des Steuergeräts beschreiben, welches sich typischerweise beim Auftreten eines bestimmten Fehlers ergibt. Ferner sind verschiedenste Ausführungsformen zwischen den beiden genannten Extremfällen (einzelne Zustandsgröße bzw. sämtliche Zustandsgrößen) denkbar und vorteilhaft. Vorzugsweise zeichnet sich der abzusichernde interne Fehlerzustand dadurch aus, dass er darin besteht, dass ein bestimmter Fehler aufgetreten ist, beispielsweise dass ein Sensor ausgefallen ist oder eine Kommunikation zwischen zwei Programm-Modulen fehlgeschlagen ist. Ebenso ist die Erfindung vorteilhaft für den Fall, dass der abzusichernde interne Fehlerzustand zwar nicht unmittelbar darin besteht, dass ein bestimmter Fehler aufgetreten ist, jedoch typischerweise auftritt, wenn ein bestimmter Fehler aufgetreten ist. Besonders vorteilhaft ist die Erfindung für den Fall, dass der abzusichernde interne Fehlerzustand sich dadurch auszeichnet, dass ein bestimmter Fehler aufgetreten ist und erkannt worden ist. Vorteilhaft kann auch der Spezialfall sein, dass der abzusichernde interne Fehlerzustand eigens zur Anzeige eines bestimmten Fehlers vorgesehen ist. Beispielsweise kann der abzusichernde interne Fehlerzustand dadurch gekennzeichnet sein, dass ein bestimmtes Fehler-Flag gesetzt ist. Die obigen Ausführungen sind so zu verstehen, dass der Gedanke des Auftretens bzw. der Erkennung zumindest eines Fehlers aus einer Vielzahl möglicher Fehler ebenfalls eingeschlossen ist.

Das derart erzeugte Testsignal wird über eine externe Datenschnittstelle an das Steuergerät übertragen und es wird zumindest der Zustand zumindest eines Fehler-Flags eines durch zumindest eine Recheneinheit des Steuergerätes ausgeführten Programms zur Laufzeit des Programms in Abhängigkeit von dem Testsignal derart verändert, dass sich der durch das Testsignal beschriebene interne Fehlerzustand einstellt. Zur Funktionsprüfung wird unter diesen Bedingungen eine Auswirkung der Veränderung auf den Betriebsablauf des Steuergeräts überwacht.

Das Testsignal wird also an das Steuergerät übertragen, um bei diesem den abzusichernden internen Fehlerzustand gezielt hervorzurufen und seine Auswirkungen zu beobachten.

Durch die Erfindung lässt sich ein beliebiger interner Fehlerzustand des Steuergeräts einstellen. Sofern Restriktionen bezüglich der Einstellbarkeit von internen Fehlerzuständen bestehen, eignet sich das Verfahren dennoch zum Hervorrufen einer Vielzahl von internen Fehlerzuständen. Indem das aus der Einstellung des internen Fehlerzustands resultierende Verhalten des Steuergeräts überwacht wird, kann beispielsweise beurteilt werden, ob der jeweilige interne Fehlerzustand einer weiteren Absicherung bedarf.

Durch die Erfindung wird somit beispielsweise ein Sicherheitsnachweis gemäß DIN IEC 61508 ermöglicht. Die Bestimmung abzusichernder Fehlerzustände kann auch anhand einer Fehlerdatenbank, einer Fehler-Möglichkeits- und Einfluss-Analyse (FMEA) bzw. einer Fehlerbaumanalyse (FTA) und/oder auf der Basis anderer systematischer bzw. statistischer Methoden erfolgen.

Bei anderen Ausführungsformen der Erfindung kann es vorteilhaft sein, wenn das Zustandssignals nur unter bestimmten Bedingungen verändert wird.

Die Erzeugung des Testsignals und/oder die Übertragung des Testsignals an das Steuergerät erfolgt vorzugsweise durch eine außerhalb des Steuergeräts angeordnete Diagnoseeinheit. Auch die erfindungsgemäße Überwachung der Auswirkung auf den Betriebsablauf des Steuergeräts erfolgt vorzugsweise durch eine außerhalb des Steuergeräts angeordnete Diagnoseeinheit, vorzugsweise dieselbe Diagnoseeinheit.

Die Erzeugung kann unmittelbar vor der Übertragung des Testsignals an das Steuergerät erfolgen. Dann können auch aktuelle Zustände und/oder Besonderheiten, beispielsweise der Gerätetyp oder eine Versionsnummer, des Steuergeräts bei der Erzeugung des Testsignals berücksichtigt werden. Das Testsignal kann beispielsweise derart in Abhängigkeit von der Software-Version des Steuergeräts erzeugt werden, dass ein bestimmter Fehlerzustand des Steuergeräts nur bei einer bestimmten Software-Version durch das Testsignal hervorgerufen wird.

Das Testsignal kann auch vorab erzeugt, zwischengespeichert und erst zu einem späteren Zeitpunkt an das Steuergerät übertragen werden. Dies ist insbesondere vorteilhaft, wenn eine Vielzahl gleichartiger oder ähnlicher Steuergeräte durch das erfindungsgemäße Verfahren funktionsgeprüft werden soll. Das Testsignal kann dann beispielsweise in einem Diagnosetester abgelegt sein und erst dann an das Steuergerät übertragen werden, wenn der Diagnosetester mit diesem verbunden ist.

Das Testsignal kann auch nach der Übertragung ins Steuergerät im Steuergerät zwischengespeichert und erst zu einem späteren Zeitpunkt verwendet werden, um den durch das Testsignal beschriebenen Fehlerzustand einzustellen. Insbesondere kann das Testsignal in den Programmcode eines durch eine Recheneinheit des Steuergeräts ausgeführten Programms integriert werden. Die Funktionsprüfung kann dann selbsttätig, insbesondere programmgesteuert, durch das Steuergerät vorgenommen werden.

Ein Programm-Modul im Sinne der oben beschriebenen Ausführungsformen der Erfindung kann sowohl ein tatsächliches programmiertechnisches Modul als auch ein Funktionsmodul im Sinne eines funktionalen Bestandteils eines Programms sein.

Durch bereits zuvor beschriebene Ausführungsformen der Erfindung kann - bei entsprechender Eignung eines durch eine Recheneinheit des Steuergeräts ausgeführten Programms - der Betriebszustand des Steuergeräts nach Vorgaben des Testsignals unmittelbar durch die Veränderung des Zustandes von zumindest einem Fehler-Flag beeinflusst werden.

Die Erfindung bietet somit die Möglichkeit, einzelne Software-Pfade gezielt anzusteuern, zu durchlaufen und somit zu testen.

Die Erfindung ermöglicht auch die Einführung von Diagnoseloops, d. h. es kann ein und derselbe Softwarepfad mehrfach, schnell durchlaufen werden um ein ausreichend hohes Vertrauenslevel der Tests zu erreichen.

Durch die Erfindung wird eine gezielte Fehlereinspeisung möglich, wodurch bei entsprechender Überwachung der Auswirkungen auf die Funktion des Steuergeräts der Nachweis und die Dokumentation einer bestimmungsgemäßen Funktion im Fehlerfall erbracht werden kann.

Auch der Testaufwand bei Änderungen des Systems kann durch die Erfindung verringert werden. Beispielsweise kann das Ausgangsverhalten eines neu einzufügenden bzw. eingefügten Programm-Moduls gegenüber den anderen Bestandteilen des Steuergeräts gezielt und systematisch emuliert werden.

Besonders vorteilhaft ist die Erfindung, wenn durch ein einzelnes Testsignal oder eine Serie von Testsignalen nacheinander eine Vielzahl von abzusichernden Fehlerzuständen hervorgerufen wird und jeweils die Auswirkungen auf die Funktion des Steuergeräts beobachtet werden. Es kann dann sehr einfach eine umfangreiche ggf. sogar vollständige Funktionsprüfung bzw. Diagnose des Steuergeräts vorgenommen werden. Die abzusichernden Fehlerzustände können beispielsweise durch eine so genannte Fehler-Möglichkeits- und Einfluss-Analyse (FMEA) bestimmt werden.

Die Erfindung ist grundsätzlich nicht auf die Anwendung auf einzelne Steuergeräte beschränkt. Sie ist vielmehr auf die Funktionsprüfung von vernetzten Systemen übertragbar. Es wird dann ein Testsignal erzeugt, welches einen abzusichernden Fehlerzustand zumindest eines Teils des vernetzten Systems beschreibt, das Testsignal wird an zumindest eine Systemkomponente übertragen, zumindest der Zustand eines Fehler-Flags eines durch eine Recheneinheit der jeweiligen Systemkomponente ausgeführten Programms wird zur Laufzeit in Abhängigkeit von dem Testsignal derart verändert, dass sich der durch das Testsignal beschriebene Fehlerzustand einstellt, und eine Auswirkung der Veränderung auf den Betriebsablauf des vernetzten Systems wird überwacht.

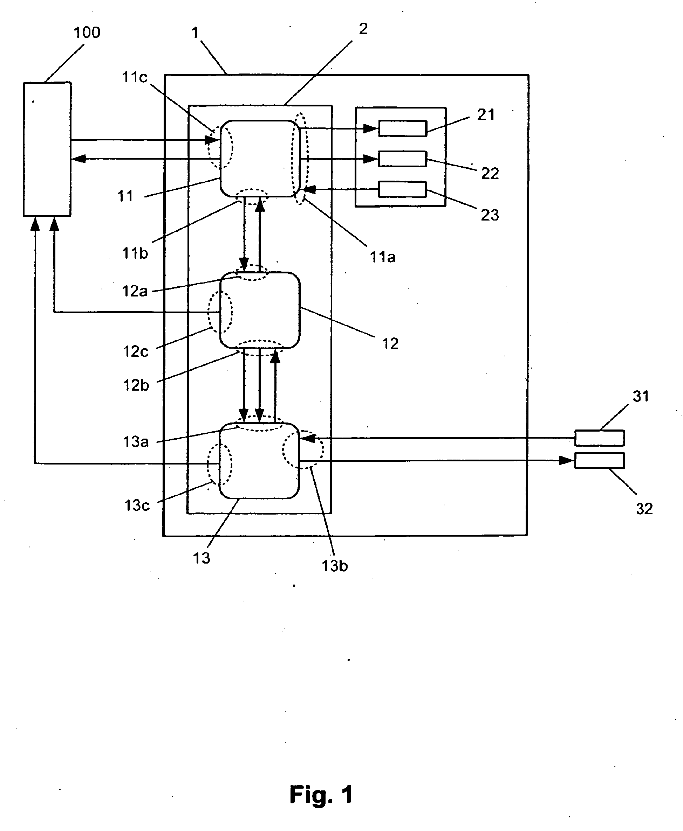

Anhand der einzigen beigefügten Zeichnung (Fig. 1) wird im Folgenden ein Ausführungsbeispiel für die Erfindung beschrieben, welches weitere vorteilhafte Ausführungsformen und Weiterbildungen der Erfindung aufzeigt. Dabei zeigt

Fig. 1 schematisch den Signalfluss bei einem erfindungsgemäßen Verfahren.

Der Signalfluss bei einem erfindungsgemäßen Verfahren zur Funktionsprüfung eines Steuergerätes 1 ist schematisch in Fig. 1 dargestellt. Das Steuergerät 1 ist als Airbag-Steuergerät in einem Kraftfahrzeug ausgebildet und besteht im Wesentlichen aus einem Mikrokontroller 2 und weiteren Hardware-Bauteilen 21, 22, 23.

Auf dem Mikrokontroller 2 läuft ein in mehrere Software-Module 11, 12, 13 untergliedertes Programm ab. Jedes der Software-Module 11, 12, 13 dient zur Darstellung einer Funktion des Steuergeräts 1. Im vorliegenden Beispiel erfüllt das Steuergerät 1 also im Wesentlichen drei verschiedene Funktionen.

Die Software-Module 11, 12, 13 kommunizieren untereinander. Die dazu erforderlichen Signalflüsse sind in Fig. 1 durch entsprechende Pfeile veranschaulicht.

Das Software-Modul 11 kommuniziert außerdem mit den Bauteilen 21, 22, 23. Auch die hierzu erforderlichen Signalflüsse sind in Fig. 1 durch entsprechende Pfeile dargestellt.

Das Software-Modul 13 kommuniziert mit zwei externen, nicht zum Steuergerät 1 gehörigen und außerhalb des Steuergeräts 1 angeordneten, Komponenten 31 und 32. Im vorliegenden Beispiel ist die Komponente 31 als externer Sensor ausgebildet, die Komponente 32 als externer Aktuator. Die Signalflüsse zwischen dem Software-Modul 13 und den Komponenten 31 und 32 sind in Fig. 1 durch entsprechende Pfeile dargestellt.

Für den zur Kommunikation erforderlichen Datenaustausch weisen die Software-Module 11, 12 und 13 geeignete Schnittstellen auf. Beispielsweise besitzt das Software-Modul 11 die in Fig. 1 dargestellten Schnittstellen 11a und 11b, das Software-Modul 12 die Schnittstellen 12a und 12b, das Software-Modul 13 die Schnittstellen 13a und 13b.

Neben den bereits genannten Schnittstellen weist das Steuergerät 1, insbesondere das Software-Modul 11, noch eine weitere Schnittstelle 11c auf, über die es mit einem Diagnosetester 100 verbunden ist. Zur Herstellung der in Fig. 1 eingezeichneten Anbindung an die Schnittstelle 11 c kann der Diagnosetester 100 an den Diagnoseanschluss des Kraftfahrzeugs angeschlossen werden, in welchem das Steuergerät 1 verbaut ist. Der Diagnoseanschluss wiederum ist über einen Datenbus mit dem Steuergerät 1 verbunden.

Von dem Diagnosetester 100 können unter anderem Daten an das Software-Modul 11 gesendet werden. Auf diese Weise kann auch ein erfindungsgemäßes Testsignal von dem Diagnosetester 100 an das Software-Modul 11 gesendet werden. Das Software-Modul 11 ist geeignet, ein solches Testsignal zu empfangen und zu interpretieren.

Das Software-Modul 11 ist ferner geeignet, abhängig vom Ergebnis der Interpretation des Testsignals, seine inneren Zustandssignale abzuändern. Der Betriebszustand des Software-Moduls 11 ist somit unmittelbar durch das Testsignal beeinflussbar.

Zudem ist das Software-Modul 11 geeignet, Inhalte des empfangenen Testsignals, welche die Software-Module 12 und 13 betreffen, über die bereits beschriebenen Datenverbindungen an die Software-Module 12 und 13 weiterzuleiten. Die Software-Module 12 und 13 sind ebenso geeignet, abhängig von den an sie weitergeleiteten Inhalten des Testsignals, innere Zustandssignale zu verändern. Somit ist auch der Betriebszustand der Software-Module 12 und 13 durch das Testsignal beeinflussbar.

Außerdem sind wesentliche Zustandssignale der Software-Module 11, 12 und 13 durch den Diagnosetester 100 beobachtbar. Hierzu werden über die bereits erwähnte Schnittstelle 11 c und entsprechende Schnittstellen 12c und 13c der Software-Module 12 und 13 entsprechende Signaldaten an den Diagnosetester 100 gesendet.

Die erfindungsgemäße Funktionsprüfung wird im Folgenden anhand von fünf Beispielfällen beschrieben.

Ein erster Beispielfall betrifft die Erprobung eines Fehlerfalls.

Es soll der interne Betriebszustand des Steuergeräts 1 "Fehler X im Software-Modul 11" erprobt werden. Der Fehler X bezeichnet dabei einen definierten Fehlerfall im Soffinrare-Modul 11. Zur Erprobung sendet der Diagnosetester 100 ein Testsignal an das Software-Modul 11. Das Testsignal enthält - vorliegend in kodierter Form - ein im Fall des Fehlers X im Software-Modul 11 von dem Software-Modul 11 über die Schnittstelle 11 b an das Software-Modul 12 ausgegebenes Ausgangssignal. Die Beschreibung des Fehlers X durch das Testsignal besteht im vorliegenden Fall also in der Vorgabe eines Ausgangssignals.

Das Software-Modul 11 empfängt das Testsignal und prägt das entsprechende Ausgangssignal der entsprechenden Schnittstelle 11 b auf. Durch das Testsignal wird also ein Zustandssignal des auf dem Mikroprozessor 2 ausgeführten Programms - hier das Ausgangssignal des Software-Moduls 11 an der Schnittstelle 11b - zur Laufzeit des Programms in Abhängigkeit von dem Testsignal verändert.

Das Software-Modul 11 verhält sich dadurch gegenüber dem Software-Modul 12 so, als ob der Fehlerfall tatsächlich eingetreten wäre. Die Veränderung des Zustandssignals erfolgt also in erfindungsgemäßer Art und Weise derart, dass sich der interne Betriebszustand des Steuergeräts "Fehler X im Software-Modul 11" - zumindest gegenüber den anderen Software-Modulen - einstellt. Wegen der Einschränkung "*zumindest gegenüber den anderen Software-Modulen*" im vorhergehenden Satz müsste eine exakte Bezeichnung des eingestellten Betriebszustands eigentlich "simulierter Fehler X im Software-Modul 11" lauten. Zu Gunsten einer besseren Lesbarkeit wird im Rahmen dieses Dokuments aber die oben verwendete kürzere Ausdrucksweise bevorzugt. An anderen Stellen dieses Dokuments wird entsprechend verfahren.

Der Diagnosetester 100 beobachtet unterdessen bestimmte Zustandssignale der Software-Module 12 und 13 und bewertet, ob deren Verhalten wunschgemäß für den simulierten Fehlerfall ist.

Auf die oben beschriebene Art und Weise kann der durch das Testsignal beschriebene Fehlerfall des Software-Moduls 11 insofern erprobt werden, als überprüft werden kann, ob die Software-Module 12 und 13 sich in dem simulierten Fehlerfall bestimmungsgemäß verhalten. Die Erprobung betrifft im vorliegenden Fall nicht das Software-Modul 11 selbst, da dessen Ausgangssignal an der Schnittstelle 11 b unmittelbar durch das Testsignal vorgegeben ist.

Ein zweiter Beispielfall betrifft - ebenso wie der erste Beispielfall - die Erprobung eines Fehlerfalls. Es soll der interne Betriebszustand des Steuergeräts 1 "Fehler Y im Software-Modul 11 erkannt" erprobt werden. Wieder sendet der Diagnosetester 100 ein Testsignal an das Software-Modul 11. In diesem zweiten Beispielfall wird ein Fehler Y des Software-Moduls 11 durch das Testsignal beschrieben, indem lediglich ein eindeutiger Fehler-Code für den Fehler Y in dem Testsignal enthalten ist. Anders als im ersten Beispielfall wird dem Software-Modul 11 durch das Testsignal jedoch kein in diesem Fehlerfall auszugebendes Ausgangssignal vorgegeben.

Das Software-Modul 11 empfängt das Testsignal, interpretiert es, erkennt den Fehler-Code und setzt ein dem beschriebenen Fehlerfall entsprechendes Fehler-Flag. Der Zustand der Fehler-Flags stellt dabei ein Zustandssignal des auf dem Mikrokontroller ausgeführten Programms dar, welches erfindungsgemäß zur Laufzeit verändert wird. Die Veränderung erfolgt erfindungsgemäß in unmittelbarer Abhängigkeit von dem Testsignal.

Gleichzeitig stellt der gesetzte bzw. aktivierte Zustand des Fehler-Flags im vorliegenden Fall den im Sinne der Erfindung abzusichernden internen Betriebszustand dar, denn das gesetzte Flag repräsentiert den durch das Testsignal beschriebenen Betriebszustand "Fehler Y im Software-Modul 11 erkannt". Es liegt dabei der Spezialfall vor, dass der abzusichernde internen Betriebszustand eigens zur Anzeige eines bestimmten Fehlers vorgesehen ist.

Ausgelöst durch den veränderten Zustand des Fehler-Flags bestimmt das Software-Modul 11 selbsttätig ein in diesem Fehlerfall an das Software-Modul 12 über die Schnittstelle 11 b auszugebendes Ausgangssignal und gibt dieses Ausgangssignal an das Software-Modul 12 aus. Bei dem Software-Modul 11 wird also der durch das Testsignal vorgegebene Fehlerfall simuliert.

Der Diagnosetester 100 beobachtet unterdessen bestimmte Zustandssignale der Software-Module 11, 12 und 13 und bewertet, ob deren Verhalten wunschgemäß ist. Insbesondere wird dabei darauf geachtet, ob alle Software-Module in geeigneter Art und Weise auf den simulierten Fehlerfall reagieren.

Im oben beschriebenen zweiten Beispielfall umfasst die Erprobung des Fehlerfalls im Gegensatz zum ersten Beispielfall also auch eine Überwachung und Bewertung der Reaktion des Software-Moduls 11.

Ein dritter Beispielfall betrifft die Erprobung eines Ausfalls eines Bauteils des Steuergeräts.

Wieder sendet der Diagnosetester 100 ein Testsignal an das Software-Modul 11. Durch das Testsignal wird dem Software-Modul 11 mitgeteilt, dass ein Ausfall des Bauteils 23 simuliert werden soll, d.h. der Betriebszustand "Ausfall des Bauteils 23" eingestellt werden soll. Das Software-Modul 11 empfängt das Testsignal, interpretiert es und erkennt als Inhalt des Testsignals den Testbefehl zur Simulation eines Ausfalls des Bauteils 23.

Das Software-Modul 11 ersetzt daraufhin das vom Bauteil 23 über die Schnittstelle 11 a empfangene Eingangssignal durch ein virtuelles Eingangssignal. Das physikalische Eingangssignal an der Schnittstelle 11a wird dabei nicht verändert. Die Ersetzung bezieht sich lediglich auf die nachfolgende digitale Verarbeitung des Eingangssignals. Das virtuelle Eingangssignal wird so festgelegt, dass es demjenigen Eingangssignal entspricht, das bei ausgefallenem Bauteil 23 an der Schnittstelle 11a anliegen würde. Entsprechende Vorschriften für die Festlegung des virtuellen Eingangssignals ergeben sich aus dem Programm-Code des auf dem Mikroprozessor 2 ausgeführten Programms.

Das verarbeitete Eingangssignal stellt dabei ein Zustandssignal dar, welches erfindungsgemäß in Abhängigkeit von dem Testsignal verändert wird. Im vorliegenden Fall ist die Abhängigkeit der Veränderung von dem Testsignal verhältnismäßig indirekt, da das Software-Modul 11 - entsprechend den Vorschriften des Programm-Codes - zunächst selbst entscheidet, wie der durch das Testsignal übermittelte Testbefehl umzusetzen ist. Das Testsignal wirkt im vorliegenden Fall gewissermaßen als Abrufkommando für die Veränderung des Zustandssignals. Als Alternative hierzu könnte - es würde dann eine engere Abhängigkeit zwischen Testsignal und verändertem Zustandssignal erreicht - in dem Testsignal eine Beschreibung des virtuellen Eingangssignals enthalten sein, durch welches das physikalische Eingangssignal zu ersetzen ist.

Durch die Ersetzung des physikalischen Eingangssignals durch das virtuelle Eingangssignal wird bei dem Steuergerät der interne Betriebszustand "Ausfall des Bauteils 23" erzeugt.

Ansonsten, d.h. abgesehen von der Ersetzung des physikalischen Eingangssignals durch das virtuelle Eingangssignal, arbeitet das Software-Modul 11 in normaler Art und Weise weiter. Dementsprechend kann der (simulierte) Ausfall des Bauteils 23, sofern bei dem Software-Modul 11 entsprechende Erkennungsmittel vorgesehen sind, durch das Software-Modul 11 erkannt werden und das Software-Modul 11 kann entsprechend reagieren.

Ebenso wie im vorhergehenden Beispielfall beobachtet der Diagnosetester 100 bestimmte Zustandssignale der Software-Module 11, 12 und 13 und bewertet, ob deren Verhalten bestimmungsgemäß ist. Insbesondere wird dabei darauf geachtet, ob der simulierte Ausfall des Bauteils 23 korrekt erkannt wird und ob alle Software-Module geeignet auf den Ausfall reagieren.

Der dritte Beispielfall zeigt also, dass durch die Erfindung der Ausfall eines Bauteils wirkungsvoll erprobt werden kann.

Ein vierter Beispielfall besitzt große Ähnlichkeit mit dem oben beschriebenen dritten Beispielfall, jedoch betrifft der vierte Beispielfall den Ausfall einer externen Komponente.

Der Diagnosetester 100 sendet ein Testsignal an das Software-Modul 11. Durch das Testsignal wird dem Software-Modul 11 mitgeteilt, dass ein Ausfall des externen Sensors 31 simuliert werden soll, d.h. der Betriebszustand "Ausfall des Sensors 31" eingestellt werden soll. Das Software-Modul 11 empfängt das Testsignal, interpretiert es und erkennt als Inhalt des Testsignals den Testbefehl zur Simulation eines Ausfalls des externen Sensors 31.

Aufgrund interner Strukturangaben ist beim Software-Modul 11 bekannt, dass lediglich das Software-Modul 13 mit dem externen Sensor 31 kommuniziert. Das Software-Modul 11 meldet dem Software-Modul 13 daher den Testbefehl zur Simulation eines Ausfalls des externen Sensors 31. Hierzu wird eine entsprechende Nachricht über das Software-Modul 12 an das Software-Modul 13 gesendet. Alternativ könnte auch das Testsignal selbst oder ein Teil desselben über das Software-Modul 12 an das Software-Modul 13 weitergeleitet werden.

Zur Umsetzung des Testbefehls ersetzt das Software-Modul 13 daraufhin das vom Sensor 31 über die Schnittstelle 13b empfangene Eingangssignal durch ein virtuelles Eingangssignal. Das physikalische Eingangssignal an der Schnittstelle 13b wird dabei nicht verändert. Hierin besteht ein wesentlicher Unterschied zu bekannten Verfahren zur Erprobung des Ausfalls externer Komponenten. Die Ersetzung bezieht sich lediglich auf die nachfolgende digitale Verarbeitung des Eingangssignals an der Schnittstelle 13b. Das virtuelle Eingangssignal wird so festgelegt, dass es demjenigen Eingangssignal entspricht, das bei ausgefallenem Sensor 31 an der Schnittstelle 13b anliegen würde.

Ansonsten, d.h. abgesehen von der Ersetzung des Eingangssignals, arbeitet das Software-Modul 13 in normaler Art und Weise weiter. Dementsprechend kann der (simulierte) Ausfall des Sensors 31, sofern bei dem Software-Modul 13 entsprechende Erkennungsmittel vorgesehen sind, durch das Software-Modul 13 erkannt werden und das Software-Modul 13 kann entsprechend reagieren.

Ebenso wie in den vorhergehenden Beispielfällen beobachtet der Diagnosetester 100 bestimmte Zustandssignale der Software-Module 11, 12 und 13 und bewertet, ob deren Verhalten für den vorliegend simulierten Fehlerfall bestimmungsgemäß ist. Insbesondere wird dabei darauf geachtet, ob der Ausfall des Sensors 31 korrekt erkannt wird und ob alle Software-Module geeignet reagieren.

Der vierte Beispielfall zeigt also, dass durch die Erfindung auch der Ausfall einer externen Komponente wirkungsvoll erprobt werden kann.

Ein fünfter Beispielfall betrifft die Erprobung des Verhaltens eines ganzen Software-Moduls.

Zunächst führt ein (nicht eigens graphisch in Fig. 1 dargestellter) externer Rechner eine Simulation eines Kommunikationsvorgangs zwischen den Software-Module 11 und 12 durch. Der Simulation liegen zumindest jeweils Verhaltensmodelle der Software-Module 11 und 12 zugrunde. Das im Rahmen des simulierten Kommunikationsvorgangs vom Software-Modul 11 an das Software-Modul 12 zu sendende Ausgangssignal wird zunächst bei dem externen Rechner zwischengespeichert. Anschließend wird es an den Diagnosetester 100 übertragen. Dieser kodiert das Ausgangssignal - zusammen mit der Informationen, dass das Ausgangssignal ein simuliertes Ausgangssignal des Software-Moduls 11 an der Schnittstelle 11 b darstellt - in ein Testsignal. Dieses Testsignal wird vom Diagnosetester an das Software-Modul 11 gesendet.

Das Software-Modul 11 empfängt das Testsignal, interpretiert es und prägt das simulativ bestimmte Ausgangssignal, welches in dem Testsignal kodiert ist, der Schnittstelle 11 b auf.

Der Diagnosetester 100 beobachtet in der Folge bestimmte Zustandssignale der Software-Module 12 und 13 und bewertet, ob deren Verhalten für den vorliegend simulierten Fall bestimmungsgemäß ist.

Im oben beschriebenen fünften Beispielfall emuliert also das Software-Modul 11 gegenüber dem Software-Modul 12 dasjenige Verhalten, das sein Verhaltensmodell in der zuvor durchgeführten Simulation gezeigt hat. Auf diese Weise kann wirkungsvoll ein bestimmtes Verhaltensmodell eines Software-Moduls im Systemverbund erprobt werden.

## Patentansprüche

1. Verfahren zur Funktionsprüfung eines Steuergerätes (1) für ein Kraftfahrzeug,
**dadurch gekennzeichnet,**
**dass** ein Testsignal erzeugt wird, welches einen abzusichernden internen Fehlerzustand eines Software-Moduls des Steuergeräts durch einen eindeutigen Fehler-Code beschreibt,
**dass** das Testsignal über eine externe Datenschnittstelle (11 c) des Steuergeräts an das Software-Modul übertragen wird,
**dass** der Zustand zumindest eines Fehler-Flags eines durch zumindest eine Recheneinheit des Steuergerätes ausgeführten Programms zur Laufzeit des Programms in Abhängigkeit von dem Testsignal derart verändert wird, dass sich der durch das Testsignal beschriebene interne Fehlerzustand einstellt, und
**dass** eine Auswirkung der Veränderung auf den Betriebsablauf des Steuergeräts überwacht wird.

## Claims

1. A method for performing a functional check on a control apparatus (1) for a motor vehicle, **characterised in that** a test signal is generated, which describes an internal fault state to be stored of a software module of the control apparatus by means of an unambiguous fault code, **in that** the test signal is transmitted to the software module via an external data interface (11c) of the control apparatus, **in that** the state of at least one fault flag of a program executed by at least one arithmetic unit of the control apparatus at the running time of the program is changed as a function of the test signal in such a way that the internal fault state described by the test signal is established, and **in that** an effect of the change on the operating sequence of the control apparatus is monitored.

## Revendications

1. Procédé de vérification du fonctionnement d'un appareil de commande (1) d'un véhicule automobile, **caractérisé en ce qu'**
- on génère un signal de test qui décrit un état de défaut interne à protéger d'un module de programme de l'appareil de commande par un code d'erreur non ambigu,
- on transmet le signal de test par une interface de données externes (11c) de l'appareil de commande au module de programme,
- on modifie l'état d'au moins un drapeau de défaut d'un programme exécuté par au moins une unité de calcul de l'appareil de commande pour le temps de fonctionnement du programme en fonction du signal de test en modifiant de façon à établir l'état d'erreur interne décrit par le signal de test, et
- on surveille l'effet de la modification sur le fonctionnement de l'appareil de commande.
